Europäisches Patentamt

European Patent Office

Office européen des brevets

(19)

(11) Numéro de publication : **0 616 398 A1**

(12) **DEMANDE DE BREVET EUROPEEN**

(21) Numéro de dépôt : **94400159.3**

(22) Date de dépôt : **25.01.94**

(51) Int. Cl.⁵ : **H01S 3/098**

(30) Priorité : **28.01.93 FR 9300870**

(43) Date de publication de la demande :
**21.09.94 Bulletin 94/38**

(84) Etats contractants désignés :
**DE GB**

(72) Inventeur : **Debeau, Jean**
**Rue de Placenn,**
**Ar Guer**
**F-22300 Lannion (FR)**
Inventeur : **Boittin, Rémi**
**Saint Lavan**
**F-22300 Ploulech (FR)**

(74) Mandataire : **Dubois-Chabert, Guy et al**
**Société de Protection des Inventions**
**25, rue de Ponthieu**
**F-75008 Paris (FR)**

(71) Demandeur : **FRANCE TELECOM**
**Etablissement autonome de droit public,**
**6, Place d'Alleray**
**F-75015 Paris (FR)**

(54) **Procédé et dispositif de génération d'impulsions optiques.**

(57)     Selon l'invention, pour engendrer un signal optique sous forme d'impulsions optiques on fait fonctionner un laser à semiconducteur (2) en commutation de gain, on réinjecte dans la laser à semiconducteur une grande partie de la lumière produite par ce laser, on filtre préalablement la lumière à réinjecter par un filtre optique (12) qui est accordé sur l'un des modes du laser, et on utilise, en tant que signal optique, une partie de la lumière produite par le laser, après avoir filtré cette partie par le filtre optique.

Application aux transmissions numériques par fibres optiques.

FIG. 1

EP 0 616 398 A1

La présente invention concerne un procédé et un dispositif de génération d'impulsions optiques.

Elle s'applique notamment aux télécommunications optiques, et plus particulièrement aux transmissions numériques par fibres optiques, notamment celles qui mettent à profit les solitons et/ou le multiplexage en longueur d'onde.

Actuellement, seuls les lasers à semiconducteur permettent d'obtenir des impulsions optiques très courtes tout en étant compatibles avec les transmissions par fibres optiques (avec ces lasers, il est possible d'obtenir des fréquences de répétition élevées et de réaliser des dispositifs de génération d'impulsions qui sont compacts).

Parmi les techniques connues de génération d'impulsions optiques, deux se sont montrées intéressantes en particulier pour la transmission d'informations par effet soliton, à savoir la technique utilisant un laser à semiconducteur qui fonctionne en blocage de modes ("mode locking") et la technique utilisant un laser à semiconducteur qui fonctionne en commutation de gain.

Dans le cas de la technique utilisant un laser qui fonctionne en blocage de modes, la cavité de type Fabry-Pérot du laser est étendue, c'est-à-dire que sa longueur initiale Lo (de l'ordre de 0,3 à 1 mm) est portée à L1 très supérieure à Lo (L1 de l'ordre de 3 à 5 cm), de manière que l'espacement Df des raies de la cavité de Fabry-Pérot se trouve dans le domaine de fréquences allant de 2 à 5 GHz environ.

Ceci est obtenu en faisant subir à l'une des faces du laser à semiconducteur un traitement anti-reflet et en disposant un miroir, ou mieux un réseau de diffraction réfléchissant, à la distance L1 de l'autre face du laser semiconducteur.

Le blocage des modes est réalisé en modulant le courant d'injection du milieu amplificateur du laser à la fréquence Df.

En faisant tourner le réseau de diffraction, on peut rendre ce laser accordable en longueur d'onde.

Un tel générateur d'impulsions optiques présente deux inconvénients majeurs :

- un tel générateur est relativement difficile à fabriquer : le traitement anti-reflet doit être de très bonne qualité et les tolérances mécaniques sont très sévères, d'où généralement un manque de robustesse,
- la fréquence de répétition des impulsions est imposée par la longueur L1 de la cavité étendue.

Il est cependant possible de rendre cette longueur L1 variable comme cela est décrit dans le document suivant :

Article de D.M. BIRD et al., intitulé "Miniature packaged actively mode-locked semiconductor laser with tunable 20ps transform limited pulses", publié dans Electronics Letters, 6 déc. 1990, vol.26, n°25, pp.2086-2087.

Mais le réglage supplémentaire décrit dans cet article accroît la difficulté de réalisation du générateur d'impulsions optiques et augmente la sensibilité de ce dernier aux contraintes mécaniques et thermiques externes.

On revient maintenant sur la technique connue qui utilise un laser à semiconducteur fonctionnant en commutation de gain.

Un laser à semiconducteur fonctionne en commutation de gain lorsque le courant d'injection de ce laser est modulé rapidement et fortement, avec un passage net de ce courant d'injection sous le seuil d'émission du laser.

Alors, la relation entre le signal de modulation et la puissance optique modulée est fortement non linéaire, ce qui permet d'obtenir, sous certaines conditions, des impulsions optiques très brèves.

Les avantages de la commutation de gain sont la simplicité, la robustesse et la possibilité de régler continûment la fréquence de répétition sur une large plage de fréquences.

L'inconvénient majeur de cette technique de commutation de gain réside dans la présence d'un fort "chirp" (fluctuation de fréquence), c'est-à-dire d'une variation importante de la longueur d'onde de l'onde porteuse optique au cours de l'impulsion.

Avec un laser mono-mode (généralement un laser de type DFB), le "chirp" peut être réduit par un traitement optique qui met généralement en oeuvre une fibre optique spéciale, dont la dispersion est négative, et/ou un filtre optique.

Un autre inconvénient d'un générateur d'impulsions optiques utilisant la commutation de gain est qu'il n'est pas accordable.

Toutefois, récemment, un générateur d'impulsions optiques accordable en longueur d'onde et utilisant le principe de la commutation de gain a été décrit dans le document suivant :

Article de M. Cavelier, N. Stelmakh, J.M. Xie, L.Chusseau, J.M. Lourtiog, C. Kazmierski et N. Bouadma, intitulé "Picosecond (<2.5 ps) Wavelength-Tunable (~20 nm/semiconductor laser pulses with repetition rates up to 12 GHz", publié dans Electronics Letters (1992), vol.28, n°3, pp.224-226.

Le laser à semiconducteur multi-modes de type Fabry- Pérot, qui est utilisé dans le générateur décrit dans ce document, est rendu d'une part monomode et d'autre part accordable en longueur d'onde par pas grâce à une faible réinjection de lumière filtrée par un filtre accordable en longueur d'onde (la puissance optique réinjectée dans le laser est de l'ordre du millième de la puissance optique produite par ce dernier, ou moins).

Cependant, le générateur décrit dans cet article a un "chirp" très important, ce qui rend ce générateur inapte aux transmissions par fibres optiques faisant intervenir le phénomène soliton.

La présente invention a pour objet un procédé et un dispositif de génération d'impulsions optiques qui combinent les avantages de la technique du blocage de modes, en particulier la qualité spectrale de l'impulsion (faible "chirp" avec un miroir sélectif), et les avantages de la technique de commutation de gain (simplicité et robustesse du dispositif de génération d'impulsions optiques).

Le procédé de génération d'un signal optique sous forme d'impulsions optiques objet de la présente invention est caractérisé en ce que :

- on fait fonctionner un laser à semiconducteur en commutation de gain,
- on réinjecte dans le laser à semiconducteur une grande partie (c'est-à-dire au moins le centième, par exemple le dixième) de la lumière produite par ce laser,
- on filtre préalablement la lumière à réinjecter par un filtre optique qui est accordé sur l'un des modes du laser, et
- on utilise, en tant que signal optique, une partie de la lumière produite par le laser, après avoir filtré cette partie par le filtre optique.

La présente invention utilise donc un laser à semiconducteur fonctionnant en commutation de gain, afin de produire des impulsions optiques, la fréquence optique de ce laser est verrouillée grâce à une forte réinjection de la puissance optique produite par ce laser et filtrée par le filtre qui est accordé sur l'un des modes du laser (qui est ainsi rendu monomode par ce filtre) et la puissance optique disponible (en vue d'une utilisation) est également filtrée par ce même filtre optique.

L'invention se distingue des techniques connues, mentionnées plus haut, par le fait qu'elle utilise la réinjection d'un fort taux de lumière filtrée dans un laser à semiconducteur qui n'a pas subi le traitement anti-reflet qui est appliqué aux lasers à cavité étendue, encore appelés lasers à cavité externe (le laser utilisé dans la présente invention ne subit aucun traitement anti-reflet ou est éventuellement soumis à un faible traitement anti-reflet afin d'augmenter la quantité de lumière sortant de ce laser).

L'invention se distingue également de ces techniques connues par le fait qu'elle utilise un filtrage, par le même filtre, de la lumière réinjectée et de la lumière disponible en vue d'une utilisation, ce qui est important pour obtenir des impulsions optiques dont l'onde porteuse optique est pure (quasiment sans "chirp").

Grâce à la réinjection d'un fort taux de lumière filtrée et à l'utilisation d'une lumière filtrée par le filtre utilisé pour la lumière à réinjecter, l'invention permet d'obtenir des impulsions optiques dont la largeur spectrale optique est proche de la limite théorique correspondant à la transformée de Fourier de l'impulsion détectée (de telles impulsions étant appelées Transform Limited Optical Pulses dans les publications en langue anglaise).

Il est à noter que plus le taux de lumière réinjectée est fort plus le "chirp" est faible.

La présente invention a également pour objet un dispositif de génération d'un signal optique sous formes d'impulsions optiques, ce dispositif étant caractérisé en ce qu'il comprend :

- un laser à semiconducteur,
- des moyens de commande du laser à semiconducteur, qui sont aptes à faire fonctionner ce laser en commutation de gain, et
- des moyens de réinjection et de fourniture prévus pour réinjecter, dans le laser, une grande partie de la lumière produite par ce laser et pour fournir, en tant que signal optique, une partie de cette lumière produite par ce laser, ces moyens de réinjection et de fourniture comprenant un filtre optique qui est accordé sur l'un des modes du laser et qui filtre préalablement la lumière à réinjecter et la lumière formant le signal optique.

Selon un premier mode de réalisation particulier du dispositif objet de l'invention, le filtre optique est réciproque et les moyens de réinjection et de fourniture comprennent en outre :

- un coupleur optique de type 2x2, ce coupleur optique ayant ainsi quatre accès dont l'un reçoit la lumière produite par le laser, cette lumière parvenant ainsi à deux autres des accès, et
- une boucle à fibre optique qui relie ces deux autres accès l'un à l'autre, par l'intermédiaire du filtre optique, le signal optique étant disponible au quatrième accès.

Dans ces conditions, la boucle à fibre optique forme un interféromètre de Sagnac.

Le dispositif objet de l'invention peut comprendre en outre au moins un contrôleur de polarisation qui est inséré dans la boucle à fibre optique.

Ceci permet de régler le taux de réinjection de lumière.

De préférence, on utilise deux contrôleurs de polarisation qui sont insérés dans la boucle à fibre optique.

Ces contrôleurs sont alors insérés, de préférence, de chaque côté du filtre optique.

De préférence, on utilise, avec le ou les contrôleurs de polarisation, un coupleur optique dont le coefficient de couplage vaut 0,5, ce qui permet de faire varier de 0% à 100% le taux de réflexion (et donc le taux de transmission) du miroir formé par la boucle à fibre optique.

Selon un deuxième mode de réalisation particulier du dispositif objet de l'invention, les moyens de réinjection et de fourniture comprennent en outre :

- un coupleur optique de type 2x2, ce coupleur optique ayant ainsi quatre accès dont l'un reçoit la lumière produite par le laser, cette lumière parvenant ainsi à deux autres des accès,
- un isolateur optique, et

- une boucle à fibre optique qui relie ces deux autres accès l'un à l'autre, par l'intermédiaire de l'isolateur optique et du filtre optique, cet isolateur et ce filtre étant insérés dans la boucle de façon à ne laisser passer que dans un sens la lumière qui circule dans cette boucle, le signal optique étant disponible au quatrième accès.

Selon un troisième mode de réalisation particulier du dispositif objet de l'invention, les moyens de réinjection et de fourniture comprennent en outre :

- un coupleur optique à au moins trois accès dont l'un est optiquement relié à la face-avant du laser à semiconducteur pour recevoir la lumière issue de cette face-avant, cette lumière parvenant alors aux deux autres accès dont l'un est optiquement relié à la face-arrière du laser pour y réinjecter une grande partie de la lumière issue de la face-avant tandis que l'autre fournit le signal optique, et
- un isolateur optique, cet isolateur et le filtre optique étant insérés dans la liaison optique entre la face-avant du laser et le coupleur optique.

Le filtre optique utilisé dans la présente invention peut être accordé une fois pour toutes sur l'une des raies de la cavité de Fabry-Pérot du laser à semiconducteur mais, de préférence, ce filtre optique est accordable en longueur d'onde, ce qui permet de passer d'une raie à une autre raie et donc d'obtenir des impulsions optiques accordables en longueur d'onde.

Enfin, les moyens de commande du laser à semiconducteur peuvent comprendre :

- un générateur d'impulsions électriques,
- un té de polarisation qui est constitué par un condensateur et une inductance et par l'intermédiaire duquel le laser est relié à ce générateur, et
- un isolateur électrique qui est placé entre le générateur et le té de polarisation et qui différencie les impulsions électriques produites par le générateur.

Ceci permet d'améliorer la forme des impulsions optiques engendrées et de réduire la largeur de ces impulsions.

La présente invention sera mieux comprise à la lecture de la description d'exemples de réalisation donnés ci-après, à titre purement indicatif et nullement limitatif, en faisant référence aux dessins annexés sur lesquels :

- la figure 1 est une vue schématique d'un mode de réalisation particulier du dispositif objet de l'invention, qui comprend une boucle à fibre optique formant un interféromètre de Sagnac,
- la figure 2A est une vue schématique de moyens utilisables dans un dispositif conforme à l'invention, pour commander le laser à semiconducteur faisant partie de ce dispositif,
- la figure 2B est une vue schématique d'autres moyens utilisés de préférence aux précédents pour commander ce laser à semiconducteur,
- la figure 3 est une vue schématique d'un autre mode de réalisation particulier du dispositif objet de l'invention, qui utilise une boucle à fibre optique dans laquelle est inséré un isolateur optique, et
- la figure 4 est une vue schématique d'un autre mode de réalisation particulier dans lequel la lumière produite par le laser à semiconducteur est réinjectée dans ce dernier par la face-arrière de ce laser.

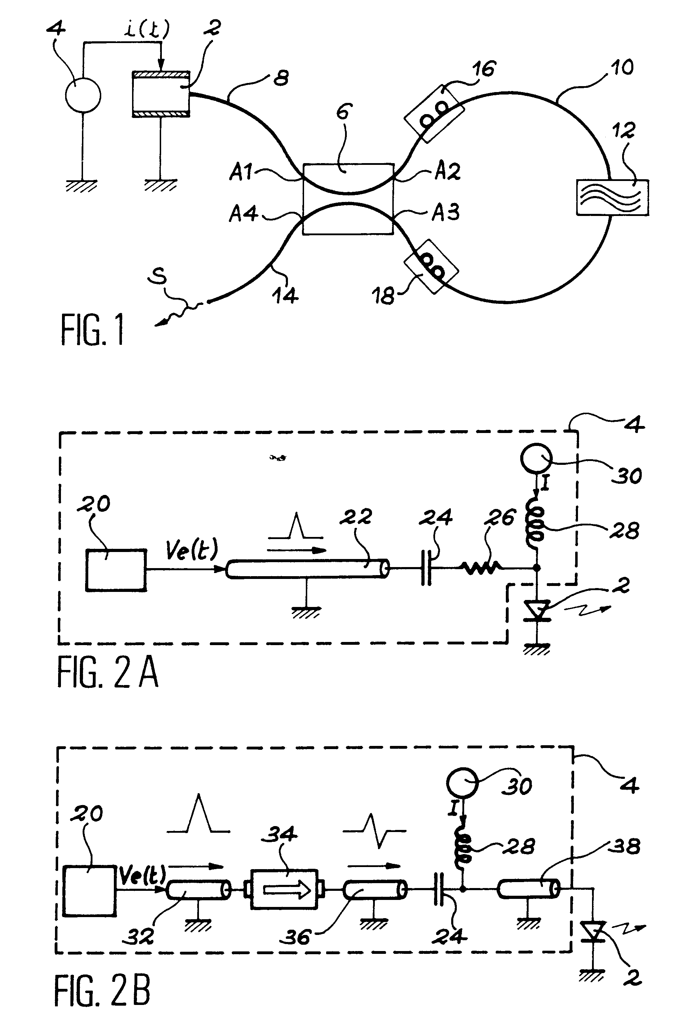

La figure 1 est une vue schématique d'un dispositif conforme à l'invention qui est particulièrement intéressant par sa simplicité.

Ce dispositif comprend un laser à semiconducteur 2, ou diode laser, et des moyens 4 de commande de cette diode laser, ces moyens de commande 4 étant prévus pour faire fonctionner la diode laser en commutation de gain.

Ces moyens de commande 4 envoient à la diode-laser 2 un courant d'injection dont les variations i(t) en fonction du temps t permettent ce fonctionnement en commutation de gain, ce courant étant appliqué à la diode laser 2 par l'intermédiaire de l'une des deux électrodes de celle-ci tandis que l'autre électrode de cette diode laser est mise à la masse.

Le dispositif de la figure 1 comprend également un coupleur optique 6 de type 2x2 dont les quatre accès portent respectivement les références A1, A2, A3 et A4 sur la figure 1.

Les impulsions optiques engendrées par la diode laser fonctionnant en commutation de gain et issues de la face-avant de cette diode laser (qui est par exemple de type DFB) sont envoyées à l'accès A1 du coupleur 6 par l'intermédiaire d'une fibre optique 8.

Chaque impulsion optique engendrée est alors divisée en deux impulsions, selon le coefficient de couplage $\underline{a}$ du coupleur optique 6 ($0 \leqq a \leqq 1$) et ces deux impulsions arrivent respectivement aux accès A2 et A3 du coupleur 6.

Le dispositif de la figure 1 comprend également une boucle à fibre optique 10 qui relie l'accès A2 à l'accès A3 du coupleur 6, par l'intermédiaire d'un filtre optique 12.

Ce filtre optique est réciproque (c'est-à-dire qu'il agit de la même façon sur une lumière qui le parcourt dans un sens que sur une lumière qui le parcourt dans l'autre sens) et ce filtre est de préférence accordable en longueur d'onde (on utilise par exemple un filtre de Fabry-Pérot accordable).

Les deux impulsions qui résultent de la division de l'impulsion optique incidente parcourent la boucle à fibre optique dans des sens inverses l'un de l'autre, traversent le filtre optique 12 et se recombinent dans le coupleur optique 6.

Une grande partie de la lumière résultant de cette recombinaison est réinjectée dans le laser 2 par l'intermédiaire de la fibre optique 8 tandis qu'une autre partie de cette lumière est disponible à l'accès A4 du coupleur optique 6.

Une fibre optique 14 peut être connectée à cet accès A4 pour transporter le signal optique S ainsi obtenu vers des moyens d'utilisation de ce signal (non représentés).

La boucle à fibre optique 10 forme un interféromètre de Sagnac :

Si la boucle à fibre optique ne contient aucun élément biréfringent et si l'on néglige les effets non-linéaires, la puissance optique qui sort par l'accès A4 du coupleur optique, rapportée à la puissance optique entrant par l'accès A1 du coupleur, est égale à

$$1 - 4a(1 - a)$$

et la puissance optique qui sort par l'accès A1 du coupleur, rapportée à la puissance optique entrant par l'accès A1 du coupleur, est égale à

$$4a(1 - a)$$

Lorsque $\underline{a}$ est égal à 0,5 (coupleur 50%-50%), toute la puissance optique est réfléchie vers la diode laser et rien ne sort par l'accès A4.

On voit donc que le coefficient de couplage $\underline{a}$ du coupleur optique 6 permet le réglage du niveau de puissance optique réinjectée dans la diode laser, ce coefficient de couplage étant figé au moment de la fabrication du coupleur optique 6.

Une manière de faire varier le taux de réflexion (et donc le taux de transmission) du miroir formé par la boucle à fibre optique est d'insérer, dans cette boucle, au moins un contrôleur de polarisation mais de préférence deux contrôleurs de polarisation 16 et 18 qui sont respectivement placés au voisinage des accès A2 et A3 du coupleur et reliés, au besoin, par la même longueur de fibre optique à ces accès A2 et A3, comme on le voit sur la figure 1.

A ce sujet, on se reportera également au document suivant :

Article de N. Finlayson, B.K. Noyar et N.J. Doran, intitulé "Switch inversion and polarization sensitivity of the nonlinear-optical loop mirror", publié dans Optics Letters, vol.17, n°2, (1992), pp.112-114.

L'utilisation du ou des contrôleurs de polarisation permet d'optimiser de façon dynamique le fonctionnement du dispositif de génération d'impulsions optiques.

La diode laser 2 est directement modulée par le courant d'injection.

Pour des fréquences de modulation supérieures ou égales à 2GHz la modulation est de type sinusoïdal.

Pour des fréquences de modulation inférieures à 2GHz, la modulation est de type impulsionnel.

Pour obtenir l'auto-verrouillage optique, il est nécessaire de synchroniser le signal de modulation de la diode laser avec les impulsions optiques réinjectées.

Cela impose que la fréquence de modulation F soit un multiple entier de la quantité Fo=1/T où T est le temps compris entre l'émission d'une impulsion optique de la part de la diode laser et la réinjection de cette impulsion dans cette diode laser.

On a déterminé expérimentalement une précision de synchronisation égale à environ 20% de la largeur à mi-amplitude tm des impulsions optiques réinjectées, ce qui permet d'évaluer la stabilité et/ou la précision de la fréquence de modulation F.

Par exemple, si F=5GHz, T=100ns (ce qui correspond à une boucle d'environ 20m de fibre optique) et tm=40 ps, la précision sur F est alors égale à $2 \times 10^{-4}$ GHz, précision et stabilité faciles à obtenir.

Dans cet exemple, le pas de fréquence Fo est égal à 10 MHz.

Ce pas Fo peut être ajusté en fonction des besoins, en jouant sur la longueur de la boucle à fibre optique, ce qui permet d'obtenir des pas très fins.

La largeur minimale des impulsions optiques engendrées dépend de nombreux facteurs dont les principaux sont la technique de fabrication de la diode laser, le circuit de commande de cette diode laser, le courant de polarisation et l'amplitude de la modulation de ce courant.

Les impulsions optiques peuvent être élargies temporellement par le choix de la bande passante du filtre optique.

Comme on l'a vu, l'utilisation d'un filtre optique accordable en longueur d'onde permet l'accord en longueur d'onde des impulsions optiques.

Les longueurs d'onde disponibles sont celles de la cavité de Fabry-Pérot de la diode laser.

Cependant, en jouant sur la température de cette diode laser, il est possible de déplacer les raies de sa cavité de Fabry-Pérot et de rendre alors continûment accordable cette diode laser.

Typiquement, une variation de 10°C suffit.

Pour les basses fréquences de répétition (typiquement inférieures à 2GHz), il est nécessaire de moduler la diode laser 2 par des impulsions de courant de grande amplitude et les plus courtes possibles.

Pour ce faire, on peut utiliser les moyens de commande 4 schématiquement représentés sur la figure 2A et comprenant un générateur 20 à diode SRD (Step Recovery Diode), qui est relié à la diode laser 2 par l'intermédiaire d'une ligne de transmission coaxiale 22 et d'un té de polarisation constitué par un condensateur 24, une résistance d'adaptation 26 et une inductance 28, cette dernière étant associée à une source de courant 30 qui fournit un courant de polarisation I.

L'impédance de sortie du générateur 20 est variable dans le temps et éloignée de l'impédance caractéristique de la ligne de transmission (50 ohms).

La résistance d'adaptation est par exemple égale à 45 ohms.

Sur la figure 2A, Ve(t) représente la tension appliquée à l'entrée de l'âme de la ligne de transmission 22 par le générateur 20 (par rapport à la masse), tension qui varie au cours du temps t.

La figure 2B montre des moyens de commande 4 qui sont utilisés de préférence aux moyens représentés sur la figure 2A.

Les moyens de commande représentés sur la figure 2B comprennent le générateur 20 de la figure 2A qui alimente la diode laser 2 successivement par l'intermédiaire d'une première ligne de transmission coaxiale 32, d'un isolateur électrique 34, d'une deuxième ligne de transmission coaxiale 36, d'un té de polarisation constitué par le condensateur 24 et l'inductance 28 associés à la source de courant 30 (la résistance d'adaptation est supprimée) et une troisième ligne de transmission coaxiale 38.

Dans le cas de la figure 2B, les impulsions électriques issues du générateur 20 sont différenciées par l'isolateur électrique 34 dont la bande passante est adaptée à la largeur de ces impulsions pour pouvoir les différencier (typiquement 1 octave).

La partie arrière de chaque impulsion électrique sortant de cet isolateur 34 est alors négative, ce qui permet de vider plus rapidement les porteurs de la zone active de la diode laser 2 et donc d'obtenir des impulsions optiques plus étroites et plus symétriques qu'avec les moyens de commande de la figure 2A.

Le fait de différencier une impulsion électrique de commande réduit l'amplitude de cette impulsion électrique.

La suppression de la résistance d'adaptation permet justement de pallier cet inconvénient.

Dans ces conditions, le courant dans la diode laser est multiplié par deux pour une même tension disponible à la sortie du générateur 20.

De plus, la suppression de cette résistance d'adaptation permet de réduire les éléments parasites de câblage.

Comme l'élément différenciateur est ici un isolateur électrique, les réflexions engendrées par la désadaptation de la diode laser sont quasiment éliminées.

Ainsi, le fait de supprimer la résistance d'adaptation de la diode laser et d'introduire un isolateur électrique, de bande passante convenable, permet d'améliorer la forme des impulsions optiques engendrées et de réduire la largeur de ces impulsions optiques.

D'autres modes de réalisation particuliers sont envisageables pour réinjecter la lumière filtrée.

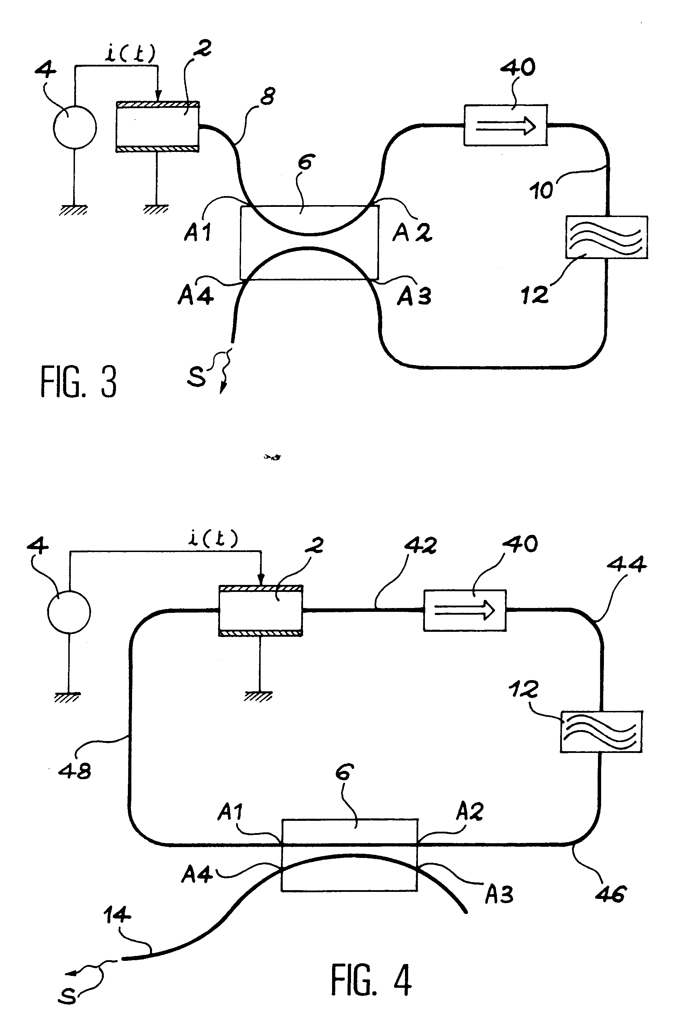

Le mode de réalisation particulier du dispositif objet de l'invention, qui est schématiquement représenté sur la figure 3, est identique à celui de la figure 1 excepté qu'un isolateur optique 40 est inséré dans la boucle à fibre optique 10 qui ne fonctionne plus alors comme un interféromètre de Sagnac (le ou les contrôleurs de polarisation sont également supprimés).

Comme on le voit sur la figure 3, l'isolateur optique 40 est monté de façon que la lumière circule dans la boucle à fibre optique 10 en allant de l'accès A2 à l'accès A3 du coupleur optique 6.

Avec le dispositif de la figure 3, le rapport de l'intensité de la lumière réinjectée dans la diode laser 2 à l'intensité de la lumière disponible à l'accès 4 du coupleur est contrôlé seulement par le coefficient a de ce coupleur.

Le mode de réalisation particulier qui est schématiquement représenté sur la figure 4 correspond au cas où la réinjection de la lumière filtrée se fait par la face-arrière de la diode laser 2 (dans le cas où à la fois la face-avant et la face-arrière de la diode laser sont accessibles).

Plus précisément, le dispositif schématiquement représenté sur la figure 4 comprend :
- la diode laser 2 qui est commandée par les moyens 4,
- le filtre optique 12 qui reçoit la lumière issue de la face-avant de la diode laser 2 successivement par l'intermédiaire d'une fibre optique 42, de l'isolateur optique optique 40 (convenablement orienté) et d'une autre fibre optique 44,
- le coupleur optique 6 dont l'accès A2 reçoit la lumière sortant du filtre optique 12 par l'intermédiaire d'une fibre optique 46 et donc l'accès A1 est relié à la face-arrière de la diode laser 2 par l'intermédiaire d'une fibre optique 48 pour y réinjecter une grande partie de la lumière produite par cette diode laser.

L'accès A4 du coupleur optique 6 est encore relié à une fibre optique 14 pour le transport du signal optique produit S tandis que l'accès A3 de ce coupleur est non connecté.

On pourrait donc remplacer le coupleur optique 6 par un coupleur en Y à trois accès (les deux branches de la fourche du Y correspondant respectivement aux accès A1 et A4).

Les fibres optiques utilisées dans la présente invention peuvent être des fibres optiques standards ou des fibres optiques à maintien de polarisation.

Ces dernières permettent d'obtenir une meilleure stabilité dans le cas d'un fonctionnement dans un environnement "difficile" (par exemple chocs mécaniques ou contraintes exercées sur les fibres optiques).

## Revendications

1. Procédé de génération d'un signal optique (S) sous forme d'impulsions optiques, ce procédé étant caractérisé en ce que :
    - on fait fonctionner un laser à semiconducteur (2) en commutation de gain,
    - on réinjecte dans le laser à semiconducteur une grande partie de la lumière produite par ce laser,

- on filtre préalablement la lumière à réinjecter par un filtre optique (12) qui est accordé sur l'un des modes du laser (2), et
- on utilise, en tant que signal optique (S), une partie de la lumière produite par le laser (2), après avoir filtré cette partie par le filtre optique (12).

2. Dispositif de génération d'un signal optique (S) sous forme d'impulsions optiques, ce dispositif étant caractérisé en ce qu'il comprend :
   - un laser à semiconducteur (2),
   - des moyens (4) de commande du laser à semiconducteur, qui sont aptes à faire fonctionner ce laser en commutation de gain, et
   - des moyens de réinjection et de fourniture prévus pour réinjecter, dans le laser (2), une grande partie de la lumière produite par ce laser et pour fournir, en tant que signal optique (S), une partie de cette lumière produite par ce laser, ces moyens de réinjection et de fourniture comprenant un filtre optique (12) qui est accordé sur l'un des modes du laser et qui filtre préalablement la lumière à réinjecter et la lumière formant le signal optique (S).

3. Dispositif selon la revendication 2, caractérisé en ce que le filtre optique (12) est réciproque et en ce que les moyens de réinjection et de fourniture comprennent en outre :
   - un coupleur optique (6) de type 2x2, ce coupleur optique ayant ainsi quatre accès dont l'un (A1) reçoit la lumière produite par le laser, cette lumière parvenant ainsi à deux autres (A2, A3) des accès, et
   - une boucle à fibre optique (10) qui relie ces deux autres accès l'un à l'autre, par l'intermédiaire du filtre optique (12), le signal optique (S) étant disponible au quatrième accès (A4).

4. Dispositif selon la revendication 3, caractérisé en ce qu'il comprend en outre au moins un contrôleur de polarisation (16, 18) qui est inséré dans la boucle à fibre optique.

5. Dispositif selon la revendication 4, caractérisé en ce qu'il comprend deux contrôleurs de polarisation (16, 18) qui sont insérés dans la boucle à fibre optique (10).

6. Dispositif selon la revendication 5, caractérisé en ce que le coefficient de couplage du coupleur optique (6) vaut 0,5.

7. Dispositif selon la revendication 2, caractérisé en ce que les moyens de réinjection et de fourniture comprennent en outre :
   - un coupleur optique (6) de type 2x2, ce coupleur optique ayant ainsi quatre accès dont l'un (A1) reçoit la lumière produite par le laser (2), cette lumière parvenant ainsi à deux autres (A2, A3) des accès,
   - un isolateur optique (40), et
   - une boucle à fibre optique (10) qui relie ces deux autres accès (A2, A3) l'un à l'autre, par l'intermédiaire de l'isolateur optique (40) et du filtre optique (12), cet isolateur et ce filtre étant insérés dans la boucle (10) de façon à ne laisser passer que dans un sens la lumière qui circule dans cette boucle, le signal optique (S) étant disponible au quatrième accès (A4).

8. Dispositif selon la revendication 2, caractérisé en ce que les moyens de réinjection et de fourniture comprennent en outre :
   - un coupleur optique (6) à au moins trois accès dont l'un (A2) est optiquement relié à la face-avant du laser à semiconducteur (2) pour recevoir la lumière issue de cette face-avant, cette lumière parvenant alors aux deux autres accès (A1, A4) dont l'un (A1) est optiquement relié à la face-arrière du laser (2) pour y réinjecter une grande partie de la lumière issue de la face-avant tandis que l'autre (A4) fournit le signal optique (S), et
   - un isolateur optique (40), cet isolateur et le filtre optique étant insérés dans la liaison optique entre la face-avant du laser (2) et le coupleur optique (6).

9. Dispositif selon l'une quelconque des revendications 2 à 8, caractérisé en ce que le filtre optique (12) est accordable en longueur d'onde.

10. Dispositif selon l'une quelconque des revendications 2 à 9, caractérisé en ce que les moyens (4) de commande du laser à semiconducteur (2) comprennent :
   - un générateur d'impulsions électriques (20),
   - un té de polarisation qui est constitué par un condensateur (24) et une inductance (28) et par l'intermédiaire duquel le laser (2) est relié à ce générateur, et
   - un isolateur électrique (34) qui est placé entre le générateur (20) et le té de polarisation et qui différencie les impulsions électriques produites par le générateur.

FIG. 1

FIG. 2 A

FIG. 2 B

FIG. 3

FIG. 4

Office européen des brevets

**RAPPORT DE RECHERCHE EUROPEENNE**

Numero de la demande
EP 94 40 0159

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| D,A | ELECTRONICS LETTERS., vol.28, no.3, 30 Janvier 1992, ENAGE GB pages 224 - 226 M.CAVALIER ET AL. 'Picosecond ( <2.5 ps ) wavelength-tunable ( 20 nm ) semiconductor laser pulses with repetition rates up to 12 GHz' * abrégé; figure 1 * | 1 | H01S3/098 |
| A | OPTICS LETTERS., vol.15, no.12, 15 Juin 1990, NEW YORK US pages 715 - 717, XP000159753 M.NAKAZAWA ET AL. 'Transform-limited pulse generation in the gigahertz region from a gain-switched distributed-feedback laser diode using spectral windowing' * abrégé; figure 1 * | 1 | |
| A | EP-A-0 468 826 (PIONEER ELECTRONIC CO.) * abrégé; figures 2,3 * | 1 | |
| A | PROCEEDINGS OF THE 14TH EUROPEAN CONFERENCE ON OPTICAL COMMUNICATION ( ECOC 88 ) 11-15 SEPTEMBER 1988 ,PART 1, BRIGHTON,UK pages 320 - 323 H.IZADPANAH 'Picosecond optical pulse generation from laser diodes operating in a novel external fiber caviry' * abrégé * | 1 | **DOMAINES TECHNIQUES RECHERCHES (Int.Cl.5)** H01S |

Le présent rapport a été établi pour toutes les revendications

| Lieu de la recherche | Date d'achèvement de la recherche | Examinateur |
|---|---|---|
| LA HAYE | 26 Avril 1994 | Galanti, M |